# FASCICULE DE BREVET EUROPEEN

(11) **EP 3 729 194 B1**
(45) Date de publication et mention de la délivrance du brevet: **03.09.2025**
(21) Numéro de dépôt: 18845466.4
(22) Date de dépôt: 19.12.2018
(51) Int. Cl.: C08F 2/38, C08F 112/08, B82Y 30/00, B82Y 40/00, G03F 7/00, B29C 33/42, B29C 33/62

(54) **PROCÉDÉ D'IMPRESSION PAR TRANSFERT**
TRANSFERDRUCKVERFAHREN
TRANSFER PRINTING METHOD

(30) Priorité: 21.12.2017 FR 1762830
(43) Date de publication de la demande: 28.10.2020
(73) Titulaire: Arkema France, 92800 Puteaux (FR)
(72) Inventeur: NAVARRO, Christophe, 64990 SAINT-PIERRE D'IRUBE (FR); NICOLET, Celia, 64230 SAUVAGNON (FR); CHEVALIER, Xavier, 38100 GRENOBLE (FR); DELACHAT, Florian, 38000 GRENOBLE (FR); TEYSSEDRE, Hubert, 38100 Grenoble (FR)
(86) Numéro de dépôt international: PCT/FR2018/053396
(87) Numéro de publication internationale: WO 2019/122705

(56) Documents cités:
- WO-A2-2012/140383
- US-A1- 2003 080 471
- US-A1- 2013 084 352
- US-A1- 2015 079 351
- DELACHAT F ET AL: "Evaluation of anti-sticking layers performances for 200mm wafer scale Smart NIL TM process through surface and defectivity characterizations", PROCEEDINGS OF SPIE; [PROCEEDINGS OF SPIE ISSN 0277-786X VOLUME 10524], SPIE, US, vol. 10586, 13 March 2018 (2018-03-13), pages 1058615 - 1058615, XP060103640, ISBN: 978-1-5106-1533-5, DOI: 10.1117/12.2298407
- LANDIS S ET AL: "Nanoimprint, DSA, and multi-beam lithography: patterning technologies with new integration challenges", PROCEEDINGS OF SPIE; [PROCEEDINGS OF SPIE ISSN 0277-786X VOLUME 10524], SPIE, US, vol. 10149, 10 April 2017 (2017-04-10), pages 101490K - 101490K, XP060087882, ISBN: 978-1-5106-1533-5, DOI: 10.1117/12.2259966

## Description

### [Domaine de l'invention]

La présente invention concerne un procédé d'impression par transfert utilisant une nouvelle famille de couches anti adhésive. Plus particulièrement, la présente invention concerne un procédé d'impression par transfert utilisant une nouvelle famille de couches anti adhésive pour les procédés de lithographie par nano impression (nanoimprint lithography en anglais).
La présente invention concerne également les empreintes obtenues à l'aide de ce procédé.

### [Problème technique et état de l'art]

La lithographie par nano impression est une méthode de fabrication de modèles à l'échelle nanométrique. C'est un processus de nano lithographie simple avec un faible coût, un haut débit et une haute résolution. Il crée des motifs par transfert de motifs existants sur un gabarit d'une formulation polymérisable ou fusible. La formulation polymérisable est typiquement une formulation de monomère et/ou de polymère qui est durcie par la chaleur ou une radiation électromagnétique pendant le procédé d'impression. Dans le cas d'une formulation fusible, cette dernière est mise en forme à la température de fusion puis refroidie. L'adhérence entre la formulation polymérisable (ou fusible) et le gabarit (le moule) est contrôlée pour permettre une libération correcte. Le contrôle de cette adhérence est, dans l'art antérieur connu (M. Keil et al., J. Vac. Sci. Technol. B 22(6), Nov/Dec 2004 ; H. Schulz et al, Proc. SPIE 3996, 244-249, 2000), assuré par un polymère portant des fonctions fluorées assurant la fonction anti adhésive d'une part, et de fonctions permettant le greffage de cette couche sur le gabarit, généralement des silanes, cette couche anti adhésive devant impérativement rester sur le gabarit.

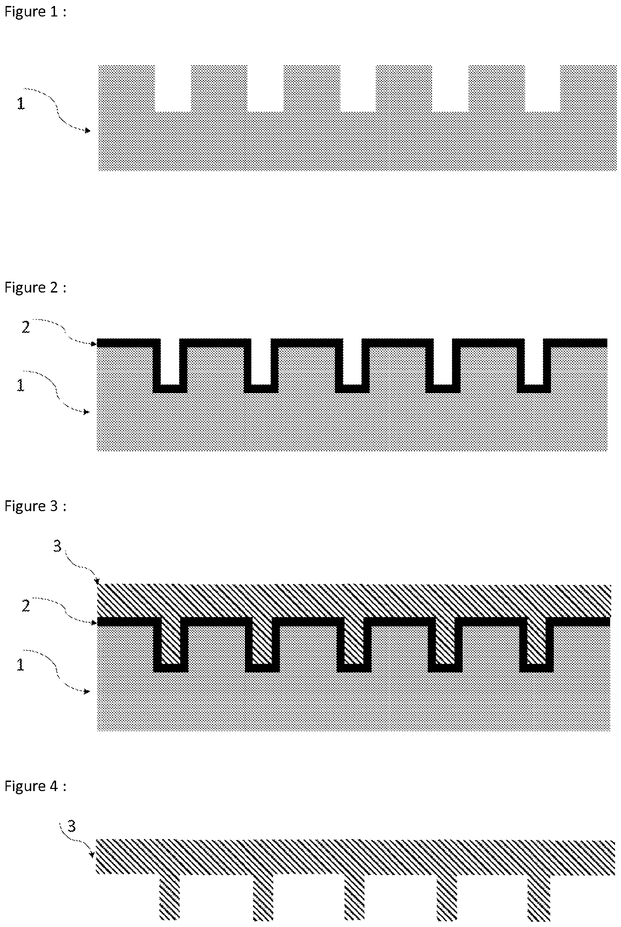

On peut résumer le procédé d'impression par transfert par les étapes suivantes :
Le gabarit 1, figure 1, est constitué d'un matériau du type silicium dans le cas de la nano impression. Pour d'autres impression par transfert, le gabarit peut être d'une autre nature minérale, métallique, voir organique.
La couche anti adhésive 2, figure 2, est constituée d'un matériau adhérent au gabarit mais non adhérent à l'empreinte.
L'empreinte 3, figure 3, est constituée d'une résine (formulation polymérisable, ou non) qui va prendre la forme du gabarit recouvert de la couche anti adhésive.
Une fois le processus terminé, l'empreinte 3 est retirée de l'ensemble 1 et 2 (figure 4).

Le cas échéant un primaire d'adhérence est rajouté entre le gabarit 1 et la couche anti adhésive 2.

La couche anti adhésive doit posséder au moins deux propriétés :
Elle doit adhérer au gabarit avec ou sans primaire d'adhésion (par exemple une activation par plasma oxygène) et elle ne doit pas adhérer à l'empreinte.

Ces deux conditions sont difficiles à réunir et des chimies élaborées sont utilisées pour réunir ces propriétés. Dans le cas de la nano impression, les solutions actuelles conduisent à des empreintes présentant trop de défauts de réplication pour satisfaire les besoins de l'électronique.

Il est en particulier largement divulgué dans la littérature que l'énergie de surface de la couche anti adhésive présentée à la formulation polymérisable doit être la plus basse possible, ceci afin d'améliorer la qualité du transfert, c'est-à-dire minimiser les défauts de transfert, mais aussi améliorer la durée de vie du matériau transféré en évitant les contaminations de surface (Bharat Bhushan, Springer Science & Business Media, 23 avr. 2010, page 291). Elle doit en outre être chimiquement inerte, hydrophobe et autoriser un bon remplissage du gabarit (ibid.), même pour de très faibles épaisseurs (quelques nanomètres dans le cas des procédé de lithographie par nano impression). Ces enseignements sont également divulgués dans US2013/0084352 et US20030080471. Ces deux documents font explicitement mention de l'utilisation de composés fluorés hydrophobes.

L'adhésion sur le gabarit est généralement assurée par des fonctions silanes tandis que les propriétés anti adhésive vis-à-vis de la formulation polymérisable sont apportées par des fonctions fluorées (ibid).

US2015/0079351 décrit ce genre de gabarit en restant en particulier sur les formulations fluorées hydrophobes avec des fonctionalités typiquement hydroxyl, amine, carboxy, thiol or sels ioniques adaptés, tel que de sodium , de potassium.

Si WO2012140383 fait mention d'un traitement de surface présentant des caractéristiques similaires au procédé décrit dans la présente invention, il est nullement mention dans ce document d'une application dans le domaine de la nano-impression qui va à l'encontre des procédés de nano-impression et des couches antiadhésives décrites dans l'art antérieur.

La demanderesse a fait une découverte surprenante en contradiction avec les propriétés communément admises relatives à la couche anti adhésive.
Elle a ainsi montré que l'énergie de surface de la couche anti adhésive du procédé de l'invention présentée à la formulation polymérisable ou non ne doit pas être la plus basse possible, certains matériaux découverts par la demanderesse à haute énergie de surface remplissant parfaitement et même mieux la fonction. Elle a aussi montré que la couche anti adhésive du procédé de l'invention n'avait pas besoin d'être aussi hydrophobe que ce qui est décrit, notamment par l'utilisation de fonctions fluorées. La nouvelle couche antiadhésive du procédé de l'invention découverte par la demanderesse ne nécessite pas nécessairement de préparation du support par l'utilisation d'un primaire d'adhérence.
Enfin la qualité des empreintes réalisées avec cette nouvelle couche antiadhésive est bien supérieure, comme le montre la quantité de défauts générés sur l'empreinte, comparativement à l'utilisation de couches anti adhésives connues.
La fabrication de la nouvelle couche antiadhésive découverte par la demanderesse est par ailleurs plus facile et plus économique à produire.

### [Résumé de l'invention]

La présente invention concerne une couche anti adhésive utilisée dans un nouveau procédé d'impression par transfert, cette couche anti adhésive comprenant un homopolymère ou un copolymère possédant au moins une liaison covalente génératrice de radicaux libres lorsque la couche anti adhésive est activée par voie thermique, oxydo-réduction organique ou inorganique, photochimique, cisaillement, plasma, ou encore sous l'influence de rayons ionisants, le dit homopolymère ou copolymère présentant une énergie de surface supérieure à 25 mN/m et un module élastique E' supérieur à 1000 MPa à 25°C et une masse moléculaire en poids supérieure à 500 g/mol.

### [Description détaillée]

Les homopolymères ou copolymères utilisés en tant que couche anti adhésive dans le procédé de l'invention peuvent être obtenus par n'importe quelle voie parmi lesquelles on peut citer la polycondensation, la polymérisation par ouverture de cycle, la polymérisation anionique, cationique ou radicalaire cette dernière pouvant être contrôlée ou non. Lorsque les copolymères sont préparés par polymérisation ou télomérisation radicalaire, celle-ci peut être contrôlée par toute technique connue telle que NMP ("Nitroxide Mediated Polymerization"), RAFT ("Reversible Addition and Fragmentation Transfer"), ATRP ("Atom Transfer Radical Polymerization"),INIFERTER ("Initiator-Transfer-Termination"), RITP ("Reverse Iodine Transfer Polymerization"), ITP ("Iodine Transfer Polymerization).

On privilégiera les procédés de polymérisation ne faisant pas intervenir de métaux. De préférence les copolymères sont préparés par polymérisation radicalaire, et plus particulièrement par polymérisation radicalaire contrôlée, encore plus particulièrement par polymérisation contrôlée par les nitroxydes.

Les homopolymères ou copolymères utilisés dans le cadre de l'invention peuvent être amorphes, cristallin ou semi cristallin, ou encore thermodurs.

Les homopolymères ou copolymères utilisés dans le cadre de l'invention répondent à la formule générale suivante : R1 A R2
A est une liaison covalente génératrice de radicaux libres dont l'énergie de liaison est comprise entre 90 et 270 KJ/mole et de préférence entre 100 et 170 KJ/mole, à 25°C mesuré selon la méthode décrite selon Kerr, Chem. Rev. 66, 465-500 (1966).

De préférence il s'agit d'une liaison carbone-oxygène telle que l'on trouve dans les alcoxyamines.
Plus particulièrement, les alcoxyamines dérivées du radical libre stable (1) sont préférées.

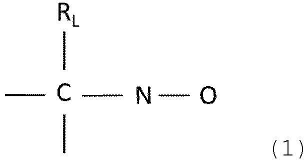

Dans laquelle le radical R_{L} présente une masse molaire supérieure à 15,0342 g/mole. Le radical R_{L} peut être un atome d'halogène tel que le chlore, le brome ou l'iode, un groupement hydrocarboné linéaire, ramifié ou cyclique, saturé ou insaturé tel qu'un radical alkyle ou phényle, ou un groupement ester -COOR ou un groupement alcoxyle -OR, ou un groupement phosphonate -PO(OR)₂, dès lors qu'il présente une masse molaire supérieure à 15,0342. Le radical R_{L}, monovalent, est dit en position β par rapport à l'atome d'azote du radical nitroxyde. Les valences restantes de l'atome de carbone et de l'atome d'azote dans la formule (1) peuvent être liées à des radicaux divers tels qu'un atome d'hydrogène, un radical hydrocarboné comme un radical alkyle, aryle ou aryle-alkyle, comprenant de 1 à 10 atomes de carbone. Il n'est pas exclu que l'atome de carbone et l'atome d'azote dans la formule (1) soient reliés entre eux par l'intermédiaire d'un radical bivalent, de façon à former un cycle. De préférence cependant, les valences restantes de l'atome de carbone et de l'atome d'azote de la formule (1) sont liées à des radicaux monovalents. De préférence, le radical R_{L} présente une masse molaire supérieure à 30 g/mole. Le radical R_{L} peut par exemple avoir une masse molaire comprise entre 40 et 450 g/mole. A titre d'exemple, le radical R_{L} peut être un radical comprenant un groupement phosphoryle, ledit radical R_{L} pouvant être représenté par la formule (2) : 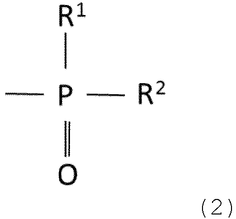 dans laquelle R¹ et R², pouvant être identiques ou différents, peuvent être choisis parmi les radicaux alkyle, cycloalkyle, alkoxyle, aryloxyle, aryle, aralkyloxyle, perfluoroalkyle, aralkyle, et peuvent comprendre de 1 à 20 atomes de carbone. R¹ et/ou R² peuvent également être un atome d'halogène comme un atome de chlore ou de brome ou de fluor ou d'iode. Le radical R_{L} peut également comprendre au moins un cycle aromatique comme pour le radical phényle ou le radical naphtyle, ce dernier pouvant être substitué, par exemple par un radical alkyle comprenant de 1 à 4 atomes de carbone.

Plus particulièrement les alcoxyamines dérivées des radicaux stables suivants sont préférées :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy nitroxide,
- 2,4,6-tri-tert-butylphenoxy nitroxide.

Outre leur énergie de liaison, les alkoxyamines utilisées en polymérisation radicalaire contrôlée doivent permettre un bon contrôle de l'enchaînement des monomères. Ainsi elles ne permettent pas toutes un bon contrôle de certains monomères. Par exemples les alcoxyamines dérivées du TEMPO ne permettent de contrôler qu'un nombre limité de monomères, il en va de même pour les alcoxyamines dérivées du 2,2,5-tri-methyl-4-phenyl-3-azahexane-3-nitroxyde (TIPNO). En revanche d'autres alcoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde permettent d'élargir à un grand nombre de monomère la polymérisation radicalaire contrôlée de ces monomères.
En outre la température d'ouverture des alcoxyamines influe également sur le facteur économique. L'utilisation de basses températures sera préférée pour minimiser les difficultés industrielles. On préfèrera donc les alkoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde à celles dérivées du TEMPO ou 2,2,5-tri-methyl-4-phenyl-3-azahexane-3-nitroxyde (TIPNO).

R1 est un homopolymère ou un copolymère et R2 est un fragment de tout type, polymère, copolymère ou non. De préférence R2 est un fragment issu de la décomposition d'amorceur de polymérisation radicalaire contrôlée ou non.

Plus préférentiellement, il s'agit pour R1 d'homopolymères, de copolymères statistiques ou à blocs, à gradient, à peigne, de masse moléculaire mesurée par SEC supérieure à 500 g/mole et pour R2 d'un groupement moléculaire de masse < 1000g/mole.

On entend par copolymère à gradient un copolymère d'au moins deux monomères obtenu généralement par polymérisation vivante ou pseudo vivante. Grâce à ces modes de polymérisation, les chaînes polymères croissent simultanément et donc incorporent à chaque instant les mêmes ratio de co-monomères. La distribution dans les chaînes polymères des co-monomères dépend donc de l'évolution, pendant la synthèse, des concentrations relatives des co-monomères. On se rapportera aux publications suivantes pour une description théorique des copolymères à gradient :T. Pakula & al., Macromol. Theory Simul. 5, 987-1006 (1996) ; A. Aksimetiev & al. J. of Chem. Physics 111, n°5 ; M. Janco J. Polym. Sci., Part A: Polym. Chem. (2000), 38(15), 2767-2778 ; M. Zaremski, & al Macromolecules (2000), 33(12), 4365-4372 ; K. Matyjaszewski & al. J. Phys. Org. Chem. (2000), 13(12), 775-786 ; Gray Polym. Prepr. (Am. Chem. Soc., Div. Polym. Chem.) (2001), 42(2), 337-338 ; K. Matyjaszewski Chem. Rev. (Washington, D. C.) (2001), 101(9), 2921-2990.

Concernant les monomères qui peuvent être utilisés pour R1, on peut citer:

Pour les précurseurs de polymères et copolymères par polycondensation : les monomères utilisés pour la préparation des polyamides ou copolyamides, polyesters ou copolyesters, polyesteramides ou copolyestersamides, polyethers, polyimides, polycétones, polyethers cetones, seuls ou en mélange.

Pour les précurseurs de polymères et copolymères par polymérisation anionique ou cationique ou par ouverture de cycle : les monomères vinylique, vinyle aromatique, vinylidénique, diénique, oléfinique, allylique ou (méth)acrylique, les lactones, carbonates, lactames, lactides ou glycolides, les oxazolines, les époxydes, les cyclosiloxanes, , seuls ou en mélange.

Pour les précurseurs de polymères et copolymères par polymérisation radicalaire :
Au moins un monomère vinylique, vinylidénique, diénique, oléfinique, allylique ou (méth)acrylique. Ce monomère est choisi plus particulièrement parmi les monomères vinylaromatiques tels que le styrène ou les styrènes substitués notamment l'alpha-méthylstyrène,les styrènes mono, di, tri quadra ou pentafluorés, les monomères acryliques tels que l'acide acrylique ou ses sels, les acrylates d'alkyle, de cycloalkyle ou d'aryle tels que l'acrylate de méthyle, d'éthyle, de butyle, d'éthylhexyle ou de phényle, les acrylates d'hydroxyalkyle tels que l'acrylate de 2-hydroxyéthyle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxypolyéthylèneglycol-polypropylèneglycol ou leurs mélanges, les acrylates d'aminoalkyle tels que l'acrylate de 2-(diméthylamino)éthyle (ADAME), les acrylates fluorés, les acrylates silylés, les acrylates phosphorés tels que les acrylates de phosphate d'alkylèneglycol,les acrylates de glycidyle, de dicyclopentenyloxyethyle, les monomères méthacryliques comme l'acide méthacrylique ou ses sels, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'hydroxyalkyle tels que le méthacrylate de 2-hydroxyéthyle ou le méthacrylate de 2-hydroxypropyle, les méthacrylates d'étheralkyle tels que le méthacrylate de 2-éthoxyéthyle, les méthacrylates d'alcoxy- ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxypolyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxy-éthylimidazolidone, le méthacrylate d'hydroxy-éthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'acide itaconique, l'acide maléique ou ses sels, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, l'hexène et le 1-octène, les monomères dièniques dont le butadiène, l'isoprène ainsi que les monomères oléfiniques fluorés, et les monomères vinylidénique, parmi lesquels on peut citer le fluorure de vinylidène, seuls ou en mélange d'au moins deux monomères précités.

De préférence R1 est un radical homopolymère, copolymère, oligomère ou co-oligomère et R2 un groupement nitroxy.

De façon préférée, R2 est le N-tertiobutyl-1-diéthylphosphono-2,2-diméthyl propyl nitroxyde.

De préférence R1 est un copolymère statistique ou homopolymère dont la masse moléculaire en nombre mesurée par SEC avec des étalons polystyrène est comprise entre 500 g et 200000 g/mole, plus préférentiellement comprise entre 1000 et 20000 g/mole, et encore plus préférentiellement comprise entre 5000 et 10000 g/mole ceci pour obtenir un dépôt de d'homopolymère ou de copolymère selon le procédé de l'invention inférieur à 50 nm, de préférence inférieure à 20 nm, de façon encore préférée inférieure à 10 nm et plus particulièrement inférieur à 5 nm. La dispersité de R1, rapport des masses moléculaires moyennes en poids au masses moléculaires moyennes en nombre est inférieure à 5, plus particulièrement inférieure à 2, et de façon préférée inférieure à 1,5.

De préférence R1 est constitué des monomères parmi lesquels on peut citer le styrène, le méthacrylate de méthyle, le méthacrylate de glycidyle (GMA), le méthacrylate de 2-hydroxy éthyle (HEMA), l'acrylate de méthyle ou d'éthyle, les acrylates ou méthacrylates fluorés, les styrènes mono, di, tri quadra ou pentafluorés. Le styrène est présent de préférence dans le copolymère dans des quantités molaires allant de 40 à 100 % et encore plus préférentiellement de 60 à 100 %.

Selon une première forme préférée de l'invention, le copolymère statistique de l'invention est préparé avec l'acide 2-méthyl-2-[N-tertiobutyl-N-(diéthoxyphosphoryl 2,2diméthylpropyl) aminoxy] propionique et le styrène.

Selon une deuxième forme préférée de l'invention, le copolymère statistique est préparé en faisant dans un premier temps réagir l'acide 2-méthyl-2-[N-tertiobutyl-N-(diéthoxyphosphoryl 2,2diméthylpropyl) aminoxy] propionique avec un monomère fonctionnel choisi parmi Le méthacrylate de glycidyle (GMA) ou le méthacrylate de 2- hydroxy éthyle, (HEMA)et de préférence l'acrylate de glycidyle (GA) ou le l'acrylate de 2- hydroxy éthyle, (HEA)de telle sorte que un seul motif monomérique soit additionné, puis dans un deuxième temps le produit de cette réaction est utilisé comme amorceur d'un ou plusieurs monomères non fonctionnels tels qu'un (meth) acrylate d'alkyle ou un monomère styrénique et de préférence le styrène seul. Ainsi dans cette forme préférée de l'invention, le copolymère de linvention est le produit de synthèse de l'acide 2-méthyl-2-[N-tertiobutyl-N-(diéthoxyphosphoryl 2,2diméthylpropyl) aminoxy] propionique avec l'acrylate d'hydroxy éthyle et styrène.

S'agissant de l'énergie de surface de l'homopolymère ou du copolymère utilisable comme couche anti adhésive dans un procédé d'impression par transfert, elle est supérieure à 25 mN/M, de préférence supérieure à 40 mN/m, mesurée par la méthode de la goutte pendante, avec traitement mathématique OWRK.

S'agissant du module élastique E' de l'homopolymère ou du copolymère utilisable comme couche anti adhésive dans un procédé d'impression par transfert, il est supérieur à 1000 MPa à 25 °C ou à la température de mise en oeuvre, mesuré par DMA (analyse mécanique dynamique).

Dans le cas des polymères amorphe, on pourra seulement considérer la Tg de l'homopolymère ou du copolymère et devra être supérieure à 25°C ou à la température de mise en œuvre, mesurée par DMA.

De plus le paramètre de Flory Huggins chi entre l'homopolymère ou le copolymère anti adhésif et la résine déposée formant l'empreinte doit être positif.

S'agissant du procédé de d'impression par transfert utilisant les couches anti adhésives objet de l'invention, il est caractérisé par les étapes suivantes :
- Dépôt d'une couche antiadhésive sur un gabarit, préalablement traité par un primaire d'adhérence (par exemple un plasma d'activation de surface) ou non, cette couche anti adhésive comprenant un homopolymère ou un copolymère possédant au moins une liaison covalente génératrice de radicaux libres lorsque l'homopolymère ou le copolymère est activée par voie thermique, oxydo-réduction organique ou inorganique, photochimique, cisaillement, plasma, ou encore sous l'influence de rayons ionisants, le dit homopolymère ou copolymère présentant une énergie de surface supérieure à 25 mN/m, un module élastique E' supérieur à 1000 MPa et une masse moléculaire en poid supérieure à 500 g/mol
- activation de la liaison covalente génératrice de radicaux libres par voie thermique, oxydo-réduction organique ou inorganique, photochimique, cisaillement, plasma, ou encore sous l'influence de rayons ionisants pour former un film d'épaisseur inférieur inférieur à 50 nm, de préférence inférieur à 20 nm, de façon encore préférée inférieur à 10 nm et plus particulièrement inférieur à 5 nm sur le gabarit.
- depot ou laminage d'une résine polymère d'épaisseur allant de 100 nm à 5 mm préalablement déposé ou non sur un support ayant un module young supérieur à 1 GPa.
- polymérisation ou refroidissement de la résine servant d'empreinte.
- retrait de l'empreinte.

Les couches anti adhésives objet de cette invention sont utilisables dans tout type de procédé d'impression par transfert (création d'empreintes), qu'il s'agisse de procédé de macro, micro, nano impression et emboutissage pour la lithographie, la microelectronique, la photonique, les applications optoelectroniques (LEDs, photovoltaiques), les MEMS, NEMS , les mémoires, la microfluidique, la biotechnology, biomedical, surfaces autonettoyantes, surfaces antireflectives, les affichages (écrans), d'impression par transfert pour la réplication de supports audios ou video tels que les CD ou DVD, ou encore les disques vinyles, ou encore d'objets plus macroscopiques tels que des objets pour des applications techniques dans les domaines du loisir, du sport, de l'automobile ou encore de l'aéronautique.

De préférence la couche antiadhésive objet de l'invention s'applique aux procédés de lithographie par nano impression.

Selon le type de procédé d'impression par transfert la nature du gabarit peut être un semiconducteur, un metal, une ceramique, un verre organique incluant les matériaux de types spin on glass et spin on carbone.

### Exemple 1

Dans cet exemple on prépare une couche antiadhésive selon l'invention (nommée ci-après ASL2-invention) :
- Préparation d'une alcoxyamine fonctionnalisée hydroxy (AM-OH, amorceur) à partir de l'alcoxyamine commerciale BlocBuilder^{®}MA commercialisée par Arkema
   Dans un ballon de 1L purgé à l'azote, on introduit :
      - 226,17 g de BlocBuilder^{®}MA (1 équivalent molaire)
      - 68,9 g d'acrylate de 2-hydroxyethyle (1 équivalent molaire)
      - 548 g d'isopropanol
   Le mélange réactionnel est chauffé à reflux (80°C) pendant 4h puis l'isopropanol est évaporé sous vide. On obtient 297 g d'alcoxyamine fonctionnalisée hydroxy (amorceur AM-OH) sous la forme d'une huile jaune très visqueuse.
- Préparation de Polystyrène fonctionnalisé
   Dans un réacteur en acier inoxydable équipé d'un agitateur mécanique et d'une double enveloppe, sont introduits 260,89 g de toluène, ainsi que 600 g de styrène et 20,89 g de l'amorceur AM-OH.
   Le mélange réactionnel est agité et dégazé par un bullage d'azote à température ambiante pendant 30 minutes.
   La température de consigne du milieu réactionnel est alors portée à 115°C (la température matière est à 108 °C). La température est maintenue à 115 °C tout le long de la polymérisation jusqu'à atteindre une conversion du monomères de 50%. Des prélèvements sont réalisés à intervalles réguliers afin de déterminer la cinétique de polymérisation par gravimétrie (mesure d'extrait sec).
   Lorsque la conversion de 50% est atteinte, le milieu réactionnel est refroidi à 60°C et le solvant et le monomère résiduel sont évaporés sous vide. Après évaporation, de la méthyléthylcétone est additionnée au milieu réactionnel en quantité telle que l'on réalise une solution de polymère de l'ordre de 25% massique.
   Cette solution de polymère est alors introduite goutte à goutte dans un bécher contenant un non-solvant (l'heptane), de manière à faire précipiter le polymère. Le ratio massique entre solvant et non-solvant (méthyléthylcétone/heptane) est de de 1/10. (v/v). Le polymère précipité est récupéré sous la forme d'une poudre blanche après filtration et séchage sous vide à 40°C pendant 48h.
   Les caractéristiques du polymère sont déterminées par chromatographie d'exclusion stérique. Le polymère est solubilisés à 1g/l dans du THF stabilisé au BHT. L'étalonnage est effectué grâce à des étalons de polystyrène monodisperses.
      - Masse molaire moyenne en nombre (Mn) : 9300 g/mol
      - Masse molaire moyenne en poids (Mw) : 11100 g/mol
      - Dispersité (Mw/Mn) : 1,19
   La solution de couche anti-adhérente est alors réalisée en introduisant 3,1 g de polymère dans 100 g d'acétate de propylène glycol méthyl éther puis récupérée après filtration sur filtre Entegris de porosité 50 nm.
   Le taux de solide est alors déterminé par gravimétrie est ajusté à 3,0 % si nécessaire par ajout de solvant.

### Exemple 2

Dans cet exemple, une évaluation des couches antiadhésives pour les procédés d'impression par transfert est réalisée en utilisant une plateforme de lithographie par nanoimpression UV (HERCULES de l'équipementier EVG) entièrement intégrée pour des plaquettes de silicium allant jusqu'à 200 mm de diamètre. Cet équipement est conçu pour la fabrication à grand volume. Le module de nanoimpression est basé sur la technologie SmartNIL^{™}.

Deux solutions de couches anti-adhésives (anti-sticking layer en anglais - ASL) sont évaluées comparativement, la couche commerciale ASL1-EVG et une couche de la nouvelle famille de couches anti-adhésives pour les procédés de lithographie par nano impression de l'invention telle que préparée dans l'exemple 1.

La couche ASL1-EVG est enduite par centrifugation sur le gabarit de silicium de 200 mm de diamètre, puis nettoyée avec un solvant commercial (hydrofluoroéther pur) (HFE). Le gabarit est ensuite chauffé sur une plaque chauffante pendant plusieurs minutes à 120 °C. La solution anti-adhésive ASL d'ARKEMA est déposée par centrifugation. Le gabarit de silicium est ensuite recuit à 200 °C pendant 75 secondes pour assurer le greffage chimique d'une couche mince uniforme. Les chaînes non greffées sont ensuite éliminées avec un rinçage au solvant (e.g. propylene glycol monomethyl ether acetate.

Les caractérisations d'énergie de surface sont généralement utilisées pour évaluer les couches anti-adhésives, car la tension interfaciale avec les liquides peut aider à prédire la le travail d'adhésion de cette couche. L'angle de contact a été mesuré, à l'aide de l'image d'une goutte immobile préalablement déposée, aux points d'intersection (points de contact triphasés) entre le contour de la goutte et la surface (ligne de base). Les angles de contact progressifs de l'eau (H₂O), du diiodométhane (CH₂I₂) et de l'éthylène glycol (C₂H₆O₂) ont été mesurés. Les énergies de surface ont été calculées à partir des angles de contact mesurés en utilisant la méthode OWRK. Les résultats sont reportés dans le tableau 1. L'énergie de surface la plus basse (13 mN/m) a été obtenue avec le gabarit traité avec le procédé standard (ASL1-EVG) tandis qu'une énergie de surface considérablement supérieure (44 mN/m) est obtenue pour la couche antiadhésive de l'invention (ASL2-invention). Une faible énergie de surface est généralement préférée pour le traitement antiadhésif car le travail d'adhérence est généralement corrélé à cette valeur. Cependant, les caractéristiques du matériau permettant de générer l'empreinte ne sont pas prises en compte par cette caractérisation. En effet, l'adhérence implique des phénomènes physico-chimiques lorsque deux surfaces sont mises en contact. Les causes de l'adhésion ne sont pas entièrement appréhendées car elles dépendent de nombreux facteurs corrélés (électrostatique, ancrage mécanique, interactions acido-basiques, inter-diffusion, création de liaisons covalentes, mouillabilité...).

Par conséquent, une caractérisation complémentaire pour évaluer l'ASL en tenant compte du matériau empreinte a été effectuée. Le matériau de l'empreinte utilisé pour évaluer les ASL est un matériau à base d'acrylique développé par EVG (référence: EVG-AS1). Ce matériau, durcissable sous rayonnement UV, peut reproduire les nanostructures d'un gabarit avec une résolution très élevée en conservant suffisamment de souplesse pour qu'il soit légèrement déformé au cours de l'impression sans endommager les nanostructures. L'approche utilisée pour caractériser l'adhérence est basée sur la méthode du « double cantilever beam » (DCB) utilisée communément pour la technologie de collage de plaquettes de silicium.

Les résultats des mesures d'énergie d'adhérence sont rapportés dans le tableau 1. Une énergie d'adhérence (G) supérieure à 600 mJ/cm² est estimée pour ASL1-EVG tandis qu'une énergie d'adhérence faible (G <200 mJ/cm²) est déterminée pour ASL2-invention. Ces résultats apportent un regard différent sur le préjugé courant qui consiste à associer une faible énergie de surface à un travail d'adhésion faible. Egalement, le matériau d'empreinte est tout d'abord distribué à l'état liquide sur la surface traitée par les couches antiadhésives. Par conséquent, la capacité du matériau empreinte à mouiller complètement la surface principale est directement liée à son énergie de surface. Ainsi une énergie de surface plus élevée telle qu'obtenue avec la couche antiadhésive de l'invention est préférable pour favoriser l'écoulement des matériaux empreinte dans le gabarit.

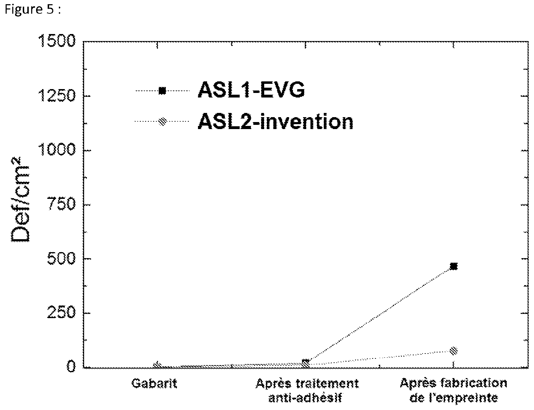

Pour compléter l'évaluation comparative des performances des couches anti-adhésives, des empreintes ont été réalisées à l'aide de plaquette de 200 mm dédiée traitées respectivement avec la couche anti-adhésive ASL1-EVG et la couche anti-adhésive de l'invention ASL2-invention. La conception du gabarit consiste en un réseau de lignes de 400 x 400 µm (dirigées verticalement et horizontalement par rapport à la direction de l'impression), de contacts et de piliers d'une densité allant de 0,1 à 0,3. Les dimensions critiques sont réparties entre 250 nm et plusieurs micromètres pour chaque type de réseaux sur une profondeur de 500 nm. Les matrices sont réparties sur une matrice de 10 x 10 mm². La matrice est répétée 240 fois sur le gabarit de 200 mm de diamètre. Les performances de l'ASL ont été évaluées à travers une mesure de défectivité réalisée sur un équipement dédié d'Applied Materials (COMPLUS 4T - Darkfield Wafer inspection system). L'inspection est effectuée par une méthode d'illumination en champ sombre. L'optimisation de la recette a été réalisée afin de réduire la contribution du bruit et d'optimiser le signal des défauts. Une sensibilité de 100 nm a été atteinte sur la recette optimisée. Des mesures d'inspection systématiques de défectivité ont été effectuées sur les deux gabarits au long du procédé de fabrication de l'empreinte. Les résultats sont reportés sur la figure 5. Nous avons observé que la défectivité de surface n'était pas impactée significativement par l'étape de traitement antiadhésif du gabarit pour les deux traitements anti-adhésifs. Cependant nous observons que la défectivité après fabrication de l'empreinte est beaucoup plus faible (~10 fois inférieure) grâce à la couche anti-adhésive de l'invention (ASL2-invention) par rapport au procédé standard (ASL1-EVG).

**Tableau 1**

| | ASL1 EVG | ASL2-invention |
|---|---|---|
| Energie de surface | 13 mN/m | 44 mN/m |
| Energie d'adhérence | 743 mJ/m² | 155 mJ/m² |

## Revendications

1. Procédé d'impression par transfert **caractérisé par** les étapes suivantes :
- Dépôt d'une couche antiadhésive sur un gabarit, préalablement traité par un primaire d'adhérence ou non, cette couche anti adhésive comprenant un homopolymère ou un copolymère possédant au moins une liaison covalente génératrice de radicaux libres lorsque l'homopolymère ou le copolymère est activé par voie thermique, oxydo-réduction organique ou inorganique, photochimique, cisaillement, plasma, ou encore sous l'influence de rayons ionisants, le dit homopolymère ou copolymère présentant une énergie de surface supérieure à 25mN/M, un module élastique E' supérieur à 1000 MPa à 25°C C et une masse moléculaire en poids supérieure à 500 g/mol.
- activation de la liaison covalente génératrice de radicaux libres par voie thermique, oxydo-réduction organique ou inorganique, photochimique, cisaillement, plasma, ou encore sous l'influence de rayons ionisants pour former un film d'épaisseur inférieur à 50 nm sur le gabarit.
- depot ou laminage d'une résine polymère d'épaisseur allant de 100 nm à 5 mm préalablement déposé ou non sur un support ayant un module young supérieur à 1 GPa.
- polymérisation ou refroidissement de la résine servant d'empreinte.
- retrait de l'empreinte.

2. Procédé selon la revendication 1 dans laquelle les liaisons covalentes génératrices de radicaux libres ont une énergie de liaison comprise entre 90 et 270 KJ/mole.

3. Procédé selon la revendication 2 dans laquelle l'homopolymère ou le copolymère sont préparés par polymérisation radicalaire contrôlée.

4. Procédé selon la revendication 3 dans laquelle l'homopolymère ou le copolymère est préparé par polymérisation radicalaire contrôlée par les nitroxydes.

5. Procédé selon la revendication 4 dans lequel les nitroxydes répondent à la formule suivante : 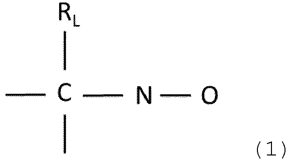 dans laquelle le radical R_{L} présente une masse molaire supérieure à 15,0342.

6. Procédé selon la revendication 5 dans lequel le nitroxyde est le N-tertiobutyl-1-diéthylphosphono-2,2-diméthyl propyl nitroxyde.

7. Utilisation du procédé de la revendication 1 dans les domaines de la macro, micro, nano, impression et emboutissage pour la lithographie, la microelectronique, la photonique, les applications optoelectroniques (LEDs, photovoltaiques), les MEMS, NEMS , les mémoires, la microfluidique, la biotechnology, biomedical, surfaces autonettoyantes, surfaces antireflectives, les affichages (écrans), d'impression par transfert pour la réplication de supports (création d'empreintes), audios ou video tels que les CD ou DVD, ou encore les disques vinyles, ou encore d'objets plus macroscopiques tels que des objets pour des applications techniques dans les domaines du loisir, du sport, de l'automobile ou encore de l'aéronautique

8. Empreinte obtenue à l'aide de l'utilisation de la revendication 7.

## Patentansprüche

1. Transferdruckverfahren, **gekennzeichnet durch** die folgenden Schritte:
- Aufbringen einer Trennschicht auf eine Schablone, die zuvor gegebenenfalls mit einem Haftvermittler behandelt worden ist, wobei diese Trennschicht ein Homopolymer oder ein Copolymer umfasst, das mindestens eine kovalente Bindung besitzt, die freie Radikale erzeugt, wenn das Homopolymer oder Copolymer thermisch, durch organische oder anorganische Redox-Reaktion, photochemisch, durch Scherung, Plasma oder unter dem Einfluss ionisierender Strahlen aktiviert wird, wobei das Homopolymer oder Copolymer eine Oberflächenenergie von mehr als 25 mN/M, ein Elastizitätsmodul E' von mehr als 1000 MPa bei 25 °C und eine Molekülmasse bezogen auf Gewicht von mehr als 500 g/mol aufweist.
- Aktivierung der freie Radikale erzeugenden kovalenten Bindung thermisch, durch organische oder anorganische Redox-Reaktion, photochemisch, durch Scherung, Plasma oder unter dem Einfluss ionisierender Strahlen zum Bilden eines Films mit einer Dicke von weniger als 50 nm auf der Schablone.
- Aufbringen oder Aufkaschieren eines Polymerharzes mit einer Dicke im Bereich von 100 nm bis 5 mm, das zuvor gegebenenfalls auf einen Träger mit einem Young-Modul von mehr als 1 GPa aufgebracht worden ist.
- Polymerisation oder Abkühlen des Harzes, was als Abdruck dient.
- Entnehmen des Abdrucks.

2. Verfahren nach Anspruch 1, wobei die freie Radikale erzeugenden kovalenten Bindungen eine Bindungsenergie zwischen 90 und 270 kJ/Mol aufweisen.

3. Verfahren nach Anspruch 2, wobei das Homopolymer oder das Copolymer durch kontrollierte radikalische Polymerisation hergestellt werden.

4. Verfahren nach Anspruch 3, wobei das Homopolymer oder das Copolymer durch kontrollierte radikalische Polymerisation mittels Nitroxiden hergestellt wird.

5. Verfahren nach Anspruch 4, wobei die Nitroxide die folgende Formel haben: 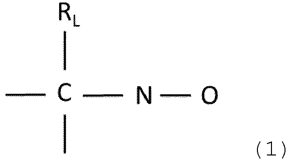 wobei das Radikal R_{L} eine Molmasse von mehr als 15,0342 aufweist.

6. Verfahren nach Anspruch 5, wobei das Nitroxid N-tert.-Butyl-1-diethylphosphono-2,2-dimethylpropylnitroxid ist.

7. Verwendung des Verfahrens nach Anspruch 1 auf den Gebieten Makro, Mikro, Nano, Druck und Prägen für die Lithographie, Mikroelektronik, Photonik, optoelektronische Anwendungen (LEDs, Photovoltaik), MEMS, NEMS, Speicher, Mikrofluidik, Biotechnologie, biomedizinisch, selbstreinigende Oberflächen, Antireflexionsoberflächen, Anzeigen (Bildschirme), Transferdruck zur Replikation von Trägern (Herstellung von Abdrücken), Audios oder Video, wie CDs oder DVDs oder Schallplatten oder makroskopischerer Objekte, wie Objekte für technische Anwendungen auf den Gebieten Freizeit, Sport, Automobil oder Aeronautik.

8. Abdruck, der durch die Verwendung nach Anspruch 7 erhalten wird.

## Claims

1. Transfer imprinting process **characterized by** the following steps:
- deposition of an anti-sticking layer on a template, treated or not treated beforehand by an adhesion primer, this anti-sticking layer comprising a homopolymer or a copolymer having at least one covalent bond that generates free radicals when the homopolymer or copolymer is activated thermally, by organic or inorganic redox, photochemically, by shearing, by plasma, or else under the influence of ionizing radiation, said homopolymer or copolymer having a surface energy of greater than 25 mN/m, an elastic modulus E' of greater than 1000 MPa at 25°C, and a weight-average molecular weight of greater than 500 g/mol,
- activation of the covalent bond that generates free radicals thermally, by organic or inorganic redox, photochemically, by shearing, by plasma, or else under the influence of ionizing radiation, in order to form a film with a thickness of less than 50 nm on the template,
- deposition or lamination of a polymer resin of a thickness ranging from 100 nm to 5 mm, whether or not deposited beforehand on a support having a Young's modulus of greater than 1 GPa,
- polymerization or cooling of the resin serving as imprint,
- removal of the imprint.

2. Process according to Claim 1, wherein the covalent bonds that generate free radicals have a bonding energy of between 90 and 270 kJ/mol.

3. Process according to Claim 2, wherein the homopolymer or the copolymer is prepared by controlled radical polymerization.

4. Process according to Claim 3, wherein the homopolymer or the copolymer is prepared by nitroxide-mediated radical polymerization.

5. Process according to Claim 4, wherein the nitroxides correspond to the following formula: 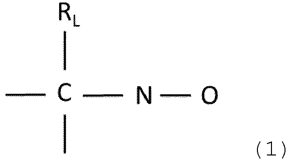 in which the radical R_{L} has a molar mass of greater than 15.0342.

6. Process according to Claim 5, wherein the nitroxide is N-(tert-butyl)-1-diethylphosphono-2,2-dimethylpropyl nitroxide.

7. Use of the process according to Claim 1 in the fields of macroimprinting, microimprinting, nanoimprinting and stamping for lithography, microelectronics, photonics, optoelectronic applications (LEDs, photovoltaics), MEMS, NEMS, memories, microfluidics, biotechnology, biomedicine, self-cleaning surfaces, anti-reflective surfaces, displays (screens), transfer imprinting for replicating supports (creating imprints), audio or video such as CDs or DVDs, or else vinyl discs, or else more macroscopic objects such as objects for technical applications in the fields of leisure, sport, cars or else aeronautics.

8. Imprint obtained by means of the use of Claim 7.
